# EUROPEAN PATENT APPLICATION

(11) **EP 4 764 538 A1**
(43) Date of publication of application: **24.06.2026**
(21) Application number: 25841509.0
(22) Date of filing: 01.07.2025
(51) Int. Cl.: G01R 31/385, G01R 31/374, G01R 31/364

(54) **APPARATUS FOR TESTING BATTERY**

(30) Priority: 16.07.2024 KR 20240094019
(71) Applicant: LG Energy Solution, Ltd., Seoul 07335 (KR)
(72) Inventor: PARK, Jin-Soo, Daejeon 34122 (KR); KIM, Chang-Hyun, Daejeon 34122 (KR); NA, Jong-Seung, Daejeon 34122 (KR); LEE, So-Jeong, Daejeon 34122 (KR); CHA, Hun, Daejeon 34122 (KR)
(74) Representative: BCKIP Part mbB
(86) International application number: PCT/KR2025/009344
(87) International publication number: WO 2026/019112

(57) **Abstract**

The present disclosure relates to a device for testing a battery having an electrode terminal, and the device may include: a power supply unit configured to supply power; a power supply path having one end connected to the electrode terminal and the other end connected to the power supply unit, and configured to provide a path through which power is supplied from the power supply unit to the electrode terminal; a temperature sensing unit disposed at least on one side of the power supply path and configured to measure a temperature of the power supply path; a heating unit disposed at least on one side of the power supply path and configured to apply heat to the power supply path; and a controller configured to control the heat application of the heating unit depending on a temperature measurement result of the temperature sensing unit.

## Description

### TECHNICAL FIELD

The present disclosure relates to a battery test device. More specifically, the present disclosure relates to a rapid battery charging test device.

This application is based on and claims priority from Korean Patent Application No. 10-2024-0094019, filed on July 16, 2024, with the Korean Intellectual Property Office, the disclosure of which is incorporated herein in its entirety by reference.

### BACKGROUND ART

Secondary batteries, which offer high applicability across product categories and possess electrical characteristics such as high energy density and the like, are widely applied not only to portable devices but also to electric vehicles (EVs) or hybrid electric vehicles (HEVs) that are driven by electric power sources. Such secondary batteries are gaining attention as a new energy source for enhancing environmental sustainability and energy efficiency not only due to their primary advantage of significantly reducing the use of fossil fuels, but also because they generate no by-products from energy usage.

Secondary batteries that are currently widely used include lithium-ion batteries, lithium polymer batteries, nickel-cadmium batteries, nickel-metal hydride batteries, and nickel-zinc batteries. When high output voltage is required, multiple battery cells may be connected in series to form a battery module or battery pack. In addition, to increase charge/discharge capacity, multiple battery cells may be connected in parallel to configure a battery module or battery pack.

A common method for configuring a battery pack by connecting multiple battery cells in series/parallel is performed by preferentially configuring a battery module including one or more battery cells and then by adding other components to one or more battery modules to configure a battery pack or battery rack. Recently, cell-to-pack-type battery packs in which multiple battery cells are directly stored in a pack housing or the like, instead of modularizing the same, have been manufactured.

Meanwhile, in order to accurately test the performance of the battery pack, such as temperature and efficiency, during rapid charging and discharging, multiple battery modules are required. However, manufacturing and testing multiple battery modules before the design of the battery module is finalized causes significant waste of time and money. In addition, when testing is performed with multiple battery modules, a problem arises where the size of the test chamber needs to be increased.

If testing is performed using one battery module, the testing conditions may differ from the actual conditions of the battery pack, which causes a problem where the temperature during rapid charging cannot be accurately predicted. In particular, in a case where multiple battery modules are electrically connected to each other, when a current cable is connected thereto, heat does not dissipate through the current cable.

However, when using one module, heat may dissipate through the current cable when it is connected.

Therefore, it is necessary to develop a structure capable of simulating, using one battery module, nearly the same conditions as a battery pack with multiple battery modules when conducting a rapid battery charging test.

### DISCLOSURE

### Technical Problem

The present disclosure is designed to solve the problems of the related art, and therefore the present disclosure is directed to providing a battery test device capable of simulating, using a single battery module, nearly the same conditions as a battery pack with multiple battery modules when conducting a rapid battery charging test.

However, the technical problems that the present disclosure seeks to solve are not limited to the above-mentioned problems, and other problems not mentioned above will be clearly understood by those skilled in the art from the description of the invention described below.

### Technical Solution

In one aspect of the present disclosure, there is provided a device for testing a battery having an electrode terminal, and the device may include: a power supply unit configured to supply power; a power supply path having one end connected to the electrode terminal and the other end connected to the power supply unit, and configured to provide a path through which power is supplied from the power supply unit to the electrode terminal; a temperature sensing unit disposed at least on one side of the power supply path and configured to measure a temperature of the power supply path; a heating unit disposed at least on one side of the power supply path and configured to apply heat to the power supply path; and a controller configured to control the heat application of the heating unit depending on a temperature measurement result of the temperature sensing unit.

The controller may be configured to uniformly maintain the temperature of the power supply path depending on the temperature of the power supply path measured by the temperature sensing unit.

The controller may be configured to control whether to operate the heating unit depending on the temperature of the power supply path measured by the temperature sensing unit.

The temperature sensing unit may include a first temperature sensing unit and a second temperature sensing unit provided on both longitudinal sides of the power supply path.

The controller may be configured to maintain a difference between a temperature measured by the first temperature sensing unit and a temperature measured by the second temperature sensing unit below a specific temperature.

The heating unit may be provided on the side of the first temperature sensing unit.

The heating unit may include a first heating unit and a second heating unit provided on both longitudinal sides of the power supply path.

The controller may be configured to operate either the first heating unit or the second heating unit in a case where a difference between the temperature measured by the first temperature sensing unit and the temperature measured by the second temperature sensing unit is equal to or greater than a specific temperature.

The controller may be configured to stop either the first heating unit or the second heating unit in a case where the difference between the temperature measured by the first temperature sensing unit and the temperature measured by the second temperature sensing unit becomes below a specific temperature after either the first heating unit or the second heating unit is operated.

The power supply path may include a first path configured to be connected to the power supply unit, and a second path configured to be connected to the first path and the electrode terminal.

The temperature sensing unit and the heating unit may be provided on the side of the second path.

The battery test device of the present disclosure may further include a storage portion configured to store the second path.

### Advantageous Effects

According to one aspect of the present disclosure, when conducting a rapid battery charging test, it is possible to simulate, using a single battery module, nearly the same conditions as a battery pack with multiple battery modules. Accordingly, the temperature of a battery pack can be accurately predicted during rapid charging with a single battery module.

Furthermore, according to one aspect of the present disclosure, the cost and time required for a rapid battery charge test can be minimized.

In addition, the present disclosure may have various other effects, and these will be described in the respective embodiments, or description of effects that may be easily inferred by those skilled in the art will be omitted.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a schematic diagram illustrating the configuration of a battery test device according to an embodiment of the present disclosure.
FIG. 2 is a schematic diagram illustrating the configuration of a battery test device according to another embodiment of the present disclosure.
FIG. 3 is a perspective view of a battery test device according to another embodiment of the present disclosure.
FIG. 4 is a schematic diagram illustrating the configuration of a battery test device according to another embodiment of the present disclosure.
FIG. 5 is a perspective view of a battery test device according to another embodiment of the present disclosure.
FIG. 6 is a schematic diagram illustrating the configuration of a battery test device according to another embodiment of the present disclosure.
FIG. 7 is a perspective view of a battery test device according to another embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, and does not represent the entire scope of the disclosure, so it should be understood that other equivalents and modifications could be made thereto without departing from the scope of the disclosure at the time of filing the present disclosure.

In addition, the present disclosure may include various embodiments. Redundant descriptions of substantially the same or similar configurations will be omitted from respective embodiments, and a description will be made based on differences therebetween.

Meanwhile, although terms indicating directions such as up(ward), down(ward), left, right, front(ward), and back(ward) are used in this specification, it is obvious to those skilled in the art to which the present disclosure pertains that these terms are only for convenience of explanation with reference to the relevant drawings and may vary depending on the position of the target object or the position of the observer.

For example, in the embodiment of the present disclosure, the X-axis direction shown in the drawing may indicate a left-right direction, the Y-axis direction may indicate a front-back direction perpendicular to the X-axis direction on the horizontal plane (X-Y plane), and the Z-axis direction may indicate an up-down direction (vertical direction), i.e., a height direction of the battery cell, perpendicular to both the X-axis direction and the Y-axis direction.

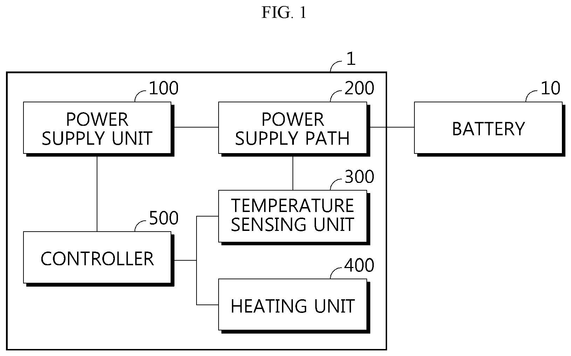

FIG. 1 is a schematic diagram illustrating the configuration of a battery test device according to an embodiment of the present disclosure.

A battery test device 1 according to the present disclosure is a device for testing a battery 10.

The battery 10 may be a battery cell. The battery cell may be a secondary battery. In addition, the battery 10 may be a battery module including a plurality of battery cells. In particular, a single battery 10 may be provided in the present disclosure.

In addition, the battery 10 may have an electrode terminal 11. The electrode terminal 11 may be configured to be electrically connected to the battery cell. The electrode terminal 11 may be configured to transmit status information about the battery 10 to an external component through the electrical connection. For example, the electrode terminal 11 may be configured to transmit voltage information of the battery cell to an external control device such as a BMS (Battery Management System). In addition, the electrode terminal 11 may be configured to transmit current from the outside to the battery 10.

Two electrode terminals 11 may be provided on both sides of the battery 10 in the widthwise direction. The electrode terminals 11 may include a negative electrode terminal and a positive electrode terminal.

Referring to FIG. 1, the battery test device 1 according to the present disclosure includes a power supply unit 100, a power supply path 200, a temperature sensing unit 300, a heating unit 400, and a controller 500.

The power supply unit 100 may be configured to supply power. The battery test device 1 may be configured to receive power from an external power source and charge the battery 10. The power source may supply charging power or receive discharging power.

The power supply path 200 may be configured to provide a path through which power is supplied from the power supply unit 100 to the electrode terminal 11. That is, current may be supplied to the battery 10 through the power supply path 200. Accordingly, the power supply path 200 may convert power supplied from the power supply unit 100 to generate current, and supply the current to the electrode terminal 11 of the battery 10.

The power supply path 200 may be configured to extend in the longitudinal direction. One end of the power supply path 200 may be connected to the electrode terminal 11 and the other end may be connected to the power supply unit 100. Connection terminals may be provided on both sides of the power supply path 200.

The temperature sensing unit 300 may be disposed on at least one side of the power supply path 200. The temperature sensing unit 300 may be configured to measure the temperature of the power supply path 200. The temperature sensing unit 300 may be configured to directly or indirectly measure the temperature of the power supply path 200. The temperature sensing unit 300 may be configured to measure the temperature around the power supply path 200.

The heating unit 400 may be disposed on at least one side of the power supply path 200. The heating unit 400 may be configured to apply heat to the power supply path 200.

The controller 500 may be configured to be electrically or communicatively connected to the temperature sensing unit 300 and the heating unit 400. The controller 500 may be configured to receive information about temperature of the power supply path 200 measured by the temperature sensing unit 300. The controller 500 may be configured to control the heat application of the heating unit 400 depending on the temperature measurement result of the temperature sensing unit 300.

According to the above-implemented configuration of the present disclosure, during a rapid charging test of the battery 10, the temperature of the side where the power supply path 200 and the battery 10 are connected may be nearly the same as the temperature of the side where the power supply unit 100 is connected. Accordingly, heat may be prevented from dissipating outside through the power supply path 200.

Therefore, according to the above-implemented configuration of the present disclosure, a rapid charging test may be performed by simulating, using a single battery 10, nearly the same conditions as those in which multiple batteries are provided. In addition, during a rapid charging test of the battery 10, the temperature of the battery 10 may be accurately measured during rapid charging.

The test may be performed by simulating, using a single battery module, nearly the same conditions as those of a battery pack including multiple battery modules. Accordingly, the temperature of the battery pack may be accurately predicted during rapid charging using a single battery module.

More specifically, the controller 500 may be configured to uniformly maintain the temperature of the power supply path 200 depending on the temperature of the power supply path 200 measured by the temperature sensing unit 300.

In addition, the controller 500 may be configured to control whether to operate the heating unit 400 depending on the temperature of the power supply path 200 measured by the temperature sensing unit 300.

For example, when the temperature of a specific part of the power supply path 200 measured by the temperature sensing unit 300 is below a specific temperature, the controller 500 may control the heating unit 400 to operate and apply heat to the specific part of the power supply path 200. Accordingly, the temperature of the specific part of the power supply path 200 may remain uniform.

In particular, during the rapid charging test of the battery 10, the temperature of a part in the power supply path 200 may decrease as it gets farther from the battery 10. However, according to the above-implemented configuration of the present disclosure, the temperature of a part of the power supply path 200, which is far from the battery 10, may be uniformly maintained, thereby preventing heat from dissipating toward the power supply unit 100.

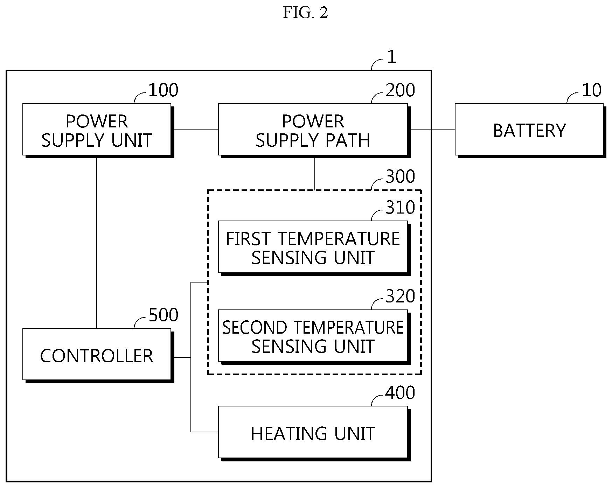

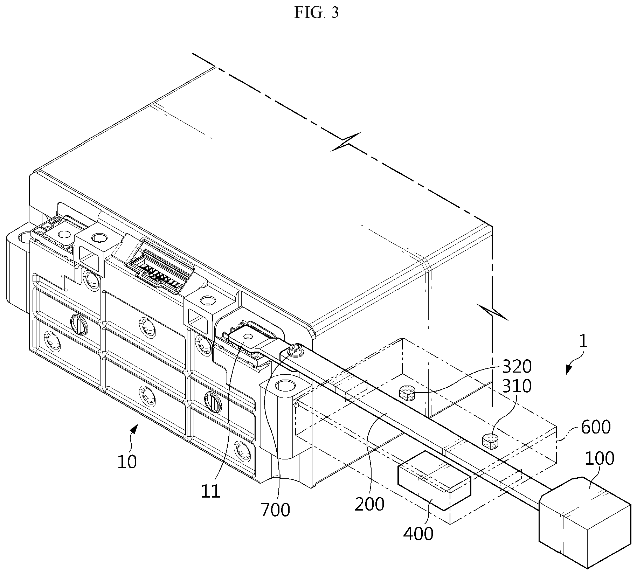

FIG. 2 is a schematic diagram illustrating the configuration of a battery test device according to another embodiment of the present disclosure, and FIG. 3 is a perspective view of a battery test device according to another embodiment of the present disclosure.

The temperature sensing unit 300 may be configured to be in direct contact with the power supply path 200. Alternatively, the temperature sensing unit 300 may be disposed to be spaced apart from the power supply path 200 by a predetermined distance.

In addition, a plurality of temperature sensing units 300 may be provided. For example, as disclosed in the embodiments illustrated in FIGS. 2 and 3, the temperature sensing units 300 may include a first temperature sensing unit 310 and a second temperature sensing unit 320.

The first temperature sensing unit 310 and the second temperature sensing unit 320 may be provided on both longitudinal sides of the power supply path 200. The first temperature sensing unit 310 may be disposed farther from the battery 10 than the second temperature sensing unit 320. For example, the first temperature sensing unit 310 may be provided closer to the power supply unit 100. The second temperature sensing unit 320 may be provided closer to the battery 10.

In this case, the controller 500 may be configured to maintain the difference between the temperature measured by the first temperature sensing unit 310 and the temperature measured by the second temperature sensing unit 320 below a specific temperature. In this specification, the temperature measured by the first temperature sensing unit 310 will be defined as a first measurement temperature, and the temperature measured by the second temperature sensing unit 320 will be defined as a second measurement temperature.

For example, the difference between the first measurement temperature and the second measurement temperature may be maintained below 0.5°C. The controller 500 may be configured to maintain the difference between the first measurement temperature and the second measurement temperature below 0.5°C.

The heating unit 400 may be configured to be in direct contact with the power supply path 200. Alternatively, the heating unit 400 may be disposed to be spaced apart from the power supply path 200 by a predetermined distance. The heating unit 400 may be configured to face the temperature sensing unit 300 with the power supply path 200 positioned therebetween.

During a rapid charging test of the battery 10, the temperature of a part of the power supply path 200 may decrease as it gets farther from the battery 10. That is, the first measurement temperature may be lower than the second measurement temperature. Accordingly, as disclosed in the embodiment illustrated in FIG. 3, the heating unit 400 may be provided on the side of the first temperature sensing unit 310.

In this case, the controller 500 may be configured to operate the heating unit 400 provided on the side of the first temperature sensing unit 310 when the difference between the first measurement temperature and the second measurement temperature is equal to or greater than a specific temperature.

According to the above-implemented configuration of the present disclosure, since the temperature may be maintained nearly the same on both longitudinal sides of the power supply path 200, it is possible to suppress dissipation of heat toward the power supply unit 100 during a rapid charging test of the battery 10.

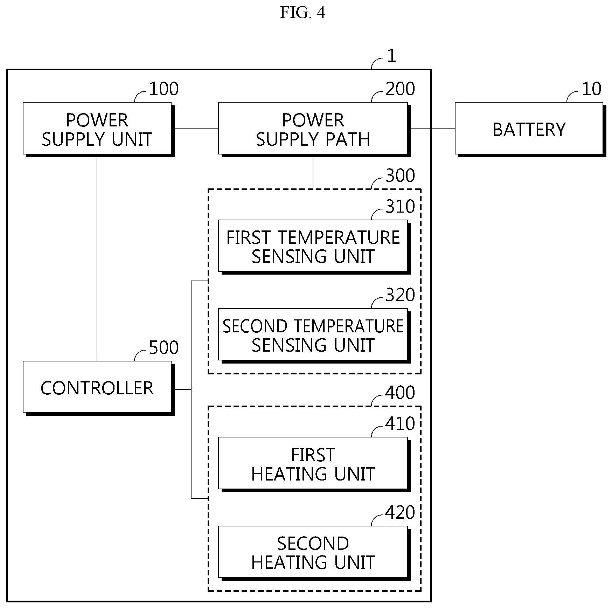

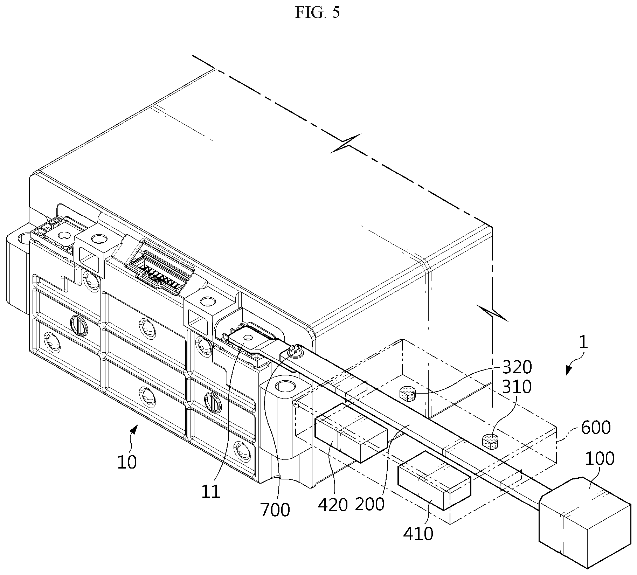

FIG. 4 is a schematic diagram illustrating the configuration of a battery test device according to another embodiment of the present disclosure, and FIG. 5 is a perspective view of a battery test device according to another embodiment of the present disclosure.

A plurality of heating units 400 may be provided. For example, as disclosed in the embodiment illustrated in FIGS. 4 and 5, the heating units 400 may include a first heating unit 410 and a second heating unit 420.

The first heating unit 410 and the second heating unit 420 may be provided on both longitudinal sides of the power supply path 200. The first heating unit 410 may be disposed farther from the battery 10 than the second heating unit 420. For example, the first heating unit 410 may be disposed closer to the power supply unit 100. The second heating unit 420 may be disposed closer to the battery 10.

In addition, the first heating unit 410 may be disposed on the side of the first temperature sensing unit 310, and the second heating unit 420 may be disposed on the side of the second temperature sensing unit 320. The first heating unit 410 may be disposed to face the first temperature sensing unit 310 with the power supply path 200 positioned therebetween. The second heating unit 420 may be disposed to face the second temperature sensing unit 320 with the power supply path 200 positioned therebetween.

The controller 500 may be configured to operate either the first heating unit 410 or the second heating unit 420 when the temperature measured by the first temperature sensing unit 310 and the temperature measured by the second temperature sensing unit 320 are different from each other. That is, the controller 500 may be configured to operate, when the first measurement temperature and the second measurement temperature are different from each other, the heating unit 400 on the side of the temperature sensing unit 300 that measured the lower of the two temperatures. In particular, when the difference between the first measurement temperature and the second measurement temperature is equal to or greater than a specific temperature, either the first heating unit 410 or the second heating unit 420 may be operated. For example, the specific temperature may be 0.5°C.

According to the above-implemented configuration of the present disclosure, the heating unit 400 provided in one of both sides of the power supply path 200, which has a lower temperature, may be operated to maintain the first measurement temperature and the second measurement temperature nearly the same, so that the temperature difference between both sides of the power supply path 200 may be maintained below a specific temperature.

In addition, when one of the first heating unit 410 and the second heating unit 420 is operated so that the difference between the temperature measured by the first temperature sensing unit 310 and the temperature measured by the second temperature sensing unit becomes below a specific temperature, the controller 500 may be configured to stop either the first heating unit 410 or the second heating unit 420. That is, the controller 500 may be configured to stop the operation of the heating unit 400 when the difference between the first measurement temperature and the second measurement temperature becomes below a specific temperature after the operation of the heating unit 400. For example, the specific temperature may be 0.5°C.

According to the above-implemented configuration of the present disclosure, since the temperature difference between both longitudinal sides of the power supply path 200 may be maintained so as not to exceed a specific temperature, it is possible to suppress heat dissipation toward the power supply unit 100 during the rapid charging test of the battery 10.

In addition, according to the above-implemented configuration of the present disclosure, when the first measurement temperature and the second measurement temperature are not the same, and when the difference between them is less than a predetermined threshold, the heating unit 400 may be prevented from operating, so that test efficiency and accuracy may be secured.

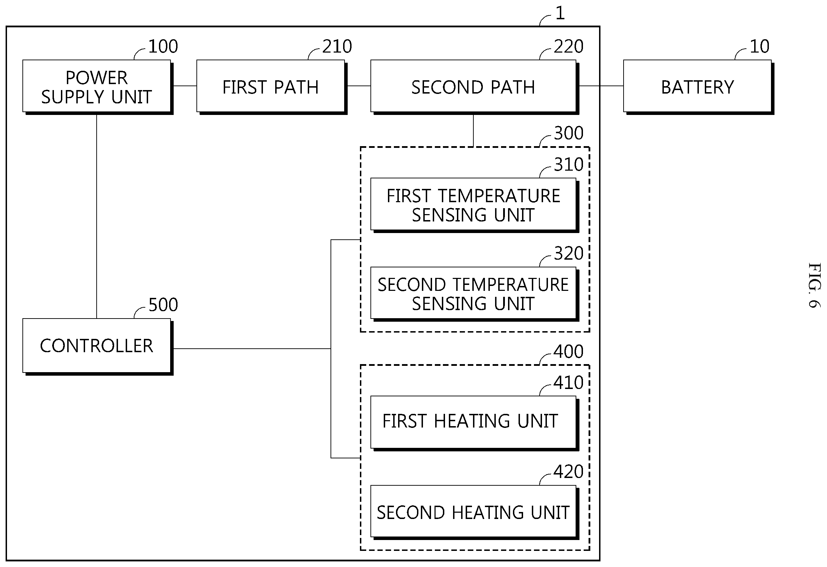

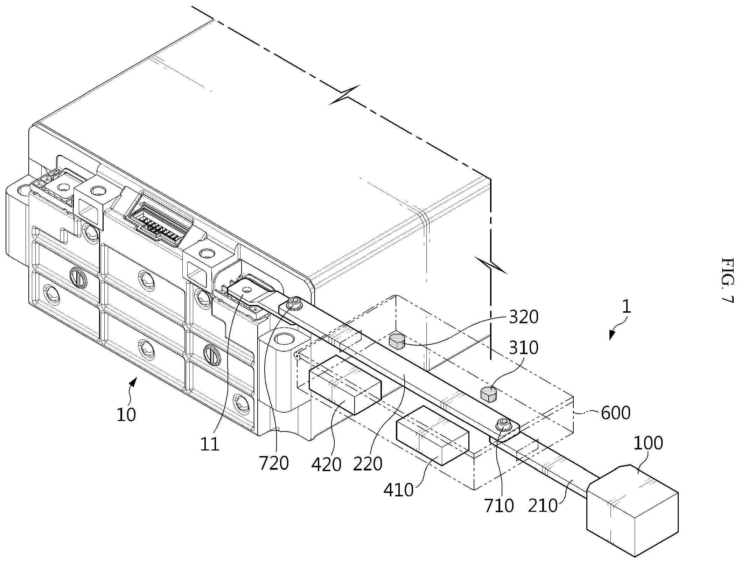

FIG. 6 is a schematic diagram illustrating the configuration of a battery test device according to another embodiment of the present disclosure, and FIG. 7 is a perspective view of a battery test device according to another embodiment of the present disclosure.

The power supply path 200 may have a plurality of paths. For example, as disclosed in the embodiments illustrated in FIGS. 6 and 7, the power supply path 200 may include a first path 210 and a second path 220. The first path 210 may be configured to be connected to the power supply unit 100. The first path 210 may be configured to provide a path through which power is supplied from the power supply unit 100.

The second path 220 may be configured to be connected to the first path 210 and the electrode terminal 11 of the battery 10. That is, one end of the second path 220 may be connected to the first path 210 and the other end may be connected to the electrode terminal 11. The second path 220 may be configured to provide a path through which power is supplied from the first path 210.

According to the above-implemented configuration of the present disclosure, since the power supply path 200 is configured in two stages, a rapid charging test of the battery 10 may be performed by connecting the second path 220 to the commercialized first path 210. As described above, test convenience may be secured.

In addition, the temperature sensing unit 300 and the heating unit 400 may be provided on the side of the second path 220.

As a more specific example, the first temperature sensing unit 310 and the second temperature sensing unit 320 may be provided on both longitudinal sides of the second path 220. The first temperature sensing unit 310 may be disposed farther from the battery 10 than the second temperature sensing unit 320. For example, the first temperature sensing unit 310 may be provided closer to the first path 210. The second temperature sensing unit 320 may be provided closer to the battery 10.

In addition, the first heating unit 410 and the second heating unit 420 may be provided on both longitudinal sides of the power supply path 200. The first heating unit 410 may be disposed farther from the battery 10 than the second heating unit 420. For example, the first heating unit 410 may be disposed closer to the first path 210. The second heating unit 420 may be disposed closer to the battery 10.

In addition, the first heating unit 410 may be disposed on the side of the first temperature sensing unit 310, and the second heating unit 420 may be disposed on the side of the second temperature sensing unit 320. The first heating unit 410 may be disposed to face the first temperature sensing unit 310 with the second path 220 positioned therebetween. The second heating unit 420 may be disposed to face the second temperature sensing unit 320 with the second path 220 positioned therebetween.

The controller 500 may be configured to operate either the first heating unit 410 or the second heating unit 420 when the temperature measured by the first temperature sensing unit 310 and the temperature measured by the second temperature sensing unit 320 are different from each other. That is, the controller 500 may be configured to operate, when the first measurement temperature and the second measurement temperature are different from each other, the heating unit 400 on the side of the temperature sensing unit 300 that measured the lower of the two temperatures. In particular, when the difference between the first measurement temperature and the second measurement temperature is equal to or greater than a specific temperature, either the first heating unit 410 or the second heating unit 420 may be operated. For example, the specific temperature may be 0.5°C.

According to the above-implemented configuration of the present disclosure, the heating unit 400 provided in one of both sides of the second path 220, which has a lower temperature, may be operated to maintain the first measurement temperature and the second measurement temperature nearly the same, so that the temperature difference between both sides of the second path 220 may be maintained below a specific temperature.

In addition, when one of the first heating unit 410 and the second heating unit 420 is operated so that the difference between the temperature measured by the first temperature sensing unit 310 and the temperature measured by the second temperature sensing unit becomes below a specific temperature, the controller 500 may be configured to stop either the first heating unit 410 or the second heating unit 420. That is, the controller 500 may be configured to stop the operation of the heating unit 400 when the difference between the first measurement temperature and the second measurement temperature becomes below a specific temperature after the operation of the heating unit 400. For example, the specific temperature may be 0.5°C.

According to the above-implemented configuration of the present disclosure, since the temperature difference between both longitudinal sides of the second path 220 may be maintained so as not to exceed a specific temperature, it is possible to suppress heat dissipation toward the first path 210 during the rapid charging test of the battery 10.

In addition, according to the above-implemented configuration of the present disclosure, when the first measurement temperature and the second measurement temperature are not the same, and when the difference between them is less than a predetermined threshold, the heating unit 400 may be prevented from operating, so that test efficiency and accuracy may be secured.

Referring to FIGS. 3, 5, and 7, the battery test device 1 according to an embodiment of the present disclosure may further include a storage portion. The storage portion 600 may be configured to store at least a portion of the power supply path 200. In particular, in the embodiment illustrated in FIG. 7, the storage portion 600 may be configured to store the second path 220.

The storage portion 600 may be configured as an electrical insulating material. In addition, the storage portion 600 may be configured as a thermal insulating material.

In addition, the storage portion 600 may be configured to store the temperature sensing unit 300 and the heating unit 400. That is, the storage portion 600 may be modularized by storing the second path 220, the temperature sensing unit 300, and the heating unit 400 therein.

According to the above-implemented configuration of the present disclosure, a rapid charging test of the battery 10 may be performed by connecting the modularized second path 220, temperature sensing unit 300, and heating unit 400 to a commercialized power supply unit 100 and power supply path 200 (e.g., the first path 210).

The storage portion 600 may be configured such that at least one side thereof is openable. Accordingly, one side of the storage portion 600 may be opened to connect the second path 220 and other components.

Furthermore, as disclosed in the embodiments illustrated in FIGS. 3, 5, and 7, one end of the power supply path 200 may be connected to the electrode terminal 11 by a fastening member 700. The fastening member 700 may be configured as a bolt or the like. The fastening member 700 may be configured to pass through the power supply path 200. Accordingly, the battery test device 1 may be configured to be attachable to and detachable from the battery 10.

In the embodiment illustrated in FIG. 7, one end of the second path 220 may be connected to the first path 210, and the other end may be connected to the electrode terminal 11. One end of the second path 220 may be connected to the first path 210 by a first fastening member 710, and the other end may be connected to the electrode terminal 11 by a second fastening member 720. The first fastening member 710 may be configured to pass through the second path 220 and the first path 210. The second fastening member 720 may be configured to pass through the second path 220 and the electrode terminal 11. Accordingly, the second path 220 may be configured to be attachable to and detachable from the battery 10 and the first path 210.

According to the above-implemented configuration of the present disclosure, the modularized second path 220, temperature sensing unit 300, and heating unit 400 may be manufactured separately, so that a rapid charging test of the battery 10 may be easily performed by connecting the module to an existing battery 10 and power supply unit 100.

As described above, although the present disclosure has been described with reference to limited embodiments and drawings, the present disclosure is not limited thereto, and various modifications and variations are possible without departing from the technical idea of the present disclosure and the scope of equivalence of the claims to be described below by those skilled in the art to which the present disclosure pertains.

## Claims

1. A device for testing a battery having an electrode terminal, the device comprising:
a power supply unit configured to supply power;
a power supply path having one end connected to the electrode terminal and the other end connected to the power supply unit, and configured to provide a path through which power is supplied from the power supply unit to the electrode terminal;
a temperature sensing unit disposed at least on one side of the power supply path and configured to measure a temperature of the power supply path;
a heating unit disposed at least on one side of the power supply path and configured to apply heat to the power supply path; and
a controller configured to control the heat application of the heating unit depending on a temperature measurement result of the temperature sensing unit.

2. The device for testing a battery according to claim 1,
wherein the controller is configured to uniformly maintain the temperature of the power supply path depending on the temperature of the power supply path measured by the temperature sensing unit.

3. The device for testing a battery according to claim 1,
wherein the controller is configured to control whether to operate the heating unit depending on the temperature of the power supply path measured by the temperature sensing unit.

4. The device for testing a battery according to claim 1,
wherein the temperature sensing unit comprises
a first temperature sensing unit and a second temperature sensing unit provided on both longitudinal sides of the power supply path.

5. The device for testing a battery according to claim 4,
wherein the controller is configured to maintain a difference between a temperature measured by the first temperature sensing unit and a temperature measured by the second temperature sensing unit below a specific temperature.

6. The device for testing a battery according to claim 4,
wherein the heating unit is provided on a side of the first temperature sensing unit.

7. The device for testing a battery according to claim 4,
wherein the heating unit comprises
a first heating unit and a second heating unit provided on both longitudinal sides of the power supply path.

8. The device for testing a battery according to claim 7,
wherein the controller is configured
to operate either the first heating unit or the second heating unit in a case where a difference between a temperature measured by the first temperature sensing unit and a temperature measured by the second temperature sensing unit is equal to or greater than a specific temperature.

9. The device for testing a battery according to claim 8,
wherein the controller is configured
to stop either the first heating unit or the second heating unit in a case where the difference between the temperature measured by the first temperature sensing unit and the temperature measured by the second temperature sensing unit becomes below a specific temperature after either the first heating unit or the second heating unit is operated.

10. The device for testing a battery according to claim 1,
wherein the power supply path comprises
a first path configured to be connected to the power supply unit, and
a second path configured to be connected to the first path and the electrode terminal.

11. The device for testing a battery according to claim 10,
wherein the temperature sensing unit and the heating unit are provided on the side of the second path.

12. The device for testing a battery according to claim 10,
further comprising a storage portion configured to store the second path.
